# EUROPÄISCHE PATENTSCHRIFT

(11) **EP 2 178 154 B1**
(45) Veröffentlichungstag und Bekanntmachung des Hinweises auf die Patenterteilung: **22.05.2013**
(21) Anmeldenummer: 09172550.7
(22) Anmeldetag: 08.10.2009
(51) Int. Cl.: H01P 3/08, H01P 3/02, H05K 1/02

(54) **Elektrische Leitungsanordnung**
Electric cable arrangement
Dispositif de ligne électrique

(30) Priorität: 15.10.2008 DE 102008042845
(43) Veröffentlichungstag der Anmeldung: 21.04.2010
(73) Patentinhaber: Robert Bosch GmbH, 70442 Stuttgart (DE)
(72) Erfinder: Wizemann, Thomas, 71642 Ludwigsburg (DE); Neumeister, Jochen, 70469 Stuttgart (DE); Wetzel, Gerhard, 70825 Korntal-Muenchingen (DE); Fucker, Frank, 71254 Ditzingen (DE); Brandl, Sonja, 70806 Kornwestheim (DE)

(56) Entgegenhaltungen:
- EP-A- 0 809 260
- EP-A- 2 068 391
- WO-A-2006/036689
- DE-A1- 19 738 754
- FR-A- 1 402 897
- JP-A- 2001 236 479

## Beschreibung

Die Erfindung betrifft eine elektrische, insbesondere einer Datenübertragung dienende Leitungsanordnung mit mindestens zwei im Wesentlichen parallel geführten elektrischen Leitern.

### Stand der Technik

Aus der WO 2006/036689 A ist eine elektrische, insbesondere zur Datenübertragung dienende Leitungsanordnung bekannt, die mindestens zwei, im Wesentlichen parallel geführte elektrische Leiter aufweist. Die Leiter überkreuzen sich an mindestens einer Stelle.

Aus der DE 197 38 754 A1 ist eine flexible, gedruckte Schaltung mit zwei elektrisch leitenden Drähten, die wellenförmig gestaltet sind und übereinander derart positioniert sind, dass sie sich abschnittsweise kreuzen.

Die JP 2001-236479 A offenbart eine kontaktlose IC-card mit einem flexiblen Substrat, auf welchem eine Spiralantennenwicklung sowie Leiterbahnen geformt sind, wobei ein Leiterelement gefaltet beziehungsweise umgebogen wird, um eine Leitungsbrücke zu bilden.

Datenübertragungen von beispielsweise symmetrischen Signalen werden im Regelfall in abgeschirmten und speziell hierfür ausgelegten Datenkabeln durchgeführt. Deren Konstruktion unterdrückt die Störaussendung der Nutzsignale über die induktive und kapazitive Koppelung, und bei der Störfestigkeit gegenüber anderen Störfeldern wird die induktive Komponente ebenfalls unterdrückt, wobei die kapazitive Kopplung zu einer Gleichtaktspannung auf den Leitungen führt, die mit geeigneten Eingangsschaltungen unterdrückt wird. Werden derartige Datensignale, also insbesondere symmetrische Signale wie beispielsweise CAN oder Flexray, über Stecker- und/oder Stanzgitterstrukturen geführt oder in einer anderen Weise parallel geführt, steigt die Störaussendung der Nutzsignale über die Einkoppelung zu anderen Leitungen, die Störunterdrückung gegenüber externen Störsignalen nimmt stark ab.

Aufgabe der Erfindung ist es, eine elektrische, insbesondere einer Datenübertragung dienenden Leitungsanordnung mit mindestens zwei im Wesentlichen parallel geführten elektrischen Leitern bereitzustellen, die die genannten Nachteile vermeidet und eine sehr störsichere Datenübertragung mit hoher Störfreiheit gegenüber externen Störfeldern als auch mit einer nur geringen Aussendung eigener Störsignale ermöglicht.

### Offenbarung der Erfindung

Hierzu wird eine elektrische, insbesondere einer Datenübertragung dienende Leitungsanordnung mit mindestens zwei im Wesentlichen parallel geführten elektrischen Leitern vorgeschlagen. Dabei ist vorgesehen, dass die Leiter mindestens eine Überkreuzung besitzen. In zweidimensionalen elektrischen Verbindungen, wie beispielsweise Stanzgittern, Leiterplatten oder auch Flexible Printed Circuits, ergeben sich die oben erwähnten nachteiligen Erscheinungen aus Koppelungen der beiden Leiter gegenüber der Umgebung. Wird aber an mindestens einer Stelle der Leiterführung eine Überkreuzung der beiden Leiter vorgesehen, hebt sich die Koppelung der beiden Leiter gegenüber der Umgebung praktisch vollständig auf. Die Überkreuzung befindet sich hierbei zur maximalen Wirksamkeit an der elektrischen Mitte der Parallelführung der beiden elektrischen Leiter, also mittig der hier betrachteten Parallelführung der beiden elektrischen Leiter. Verlaufen diese also beispielsweise für eine bestimmte Strecke s parallel (nämlich der elektrischen Länge), ist die Mitte der Überkreuzung zur maximalen Wirksamkeit bei s/2. Sind mehrere Überkreuzungen auf die elektrische Länge verteilt vorgesehen, so sind diese bevorzugt gleichmäßig beabstandet und verteilt.

Erfindungsgemäß weist die Überkreuzung mindestens ein separates, elektrisch verbundenes Leiterelement auf. Die Überkreuzung wird so ausgeführt, dass eine Unterbrechung eines der Leiter bei Anordnungsversatz erfolgt. Um die Leiter in der Überkreuzung in der gewünschten Art und Weise elektrisch verbunden zu halten, wird mindestens ein separates, elektrisch verbundenes Leiterelement verwendet.

In einer Ausführungsform sind die Leiter als Leiterbahnen ausgebildet. Unter Leiterbahnen werden hier im weitesten Sinne alle auf einem Substrat unmittelbar aufliegenden Leiter verstanden, beispielsweise Kupferleiterbahnen auf einer Platine.

Erfindungsgemäß sind die Leiter auf einem flexiblen Substrat ausgebildet. Als flexibles Substrat kommt beispielsweise eine Folie in Betracht, auf der die Leiter aufgebracht sind.

Beispielsweise erfolgt die Überkreuzung durch eine S-förmige Ausbildung der Leiter und eine durch Faltung des Substrats erfolgende, zumindest bereichsweise Überdeckung der Leiter im Bereich der S-förmigen Ausbildung. Dieses Beispiel ist bei Aufbringung der Leiter auf einem flexiblen Substrat besonders vorteilhaft, da sie durch eine entsprechende Anordnung der Leiter, wie beschrieben in S-förmiger Ausbildung, und durch einfache Faltung des flexiblen Substrats ermöglicht wird. Die Faltung muss hierbei nicht eine Aufeinanderlage der Substratflächen oder Substratteile bewirken, sondern diese können auch beabstandet liegen; wesentlich ist allein, dass die S-förmige Ausbildung der Leiter in entsprechende Gegenüberlage kommt, um die Überkreuzung auszubilden (die sich beispielsweise als Projektion durch beide, gefaltete Substratflächen ergibt).

In einer anderen Ausführungsform sind die Leiter als Stanzgitterbahnen ausgebildet. Stanzgitter finden zur Übertragung von teilweise auch hohen Strömen insbesondere in der Automobiltechnik Anwendung. Bevorzugt ist es hierbei möglich, über solche Stanzgitterbahnen auch Datensignale zu übertragen, wobei die Übertragung von Datensignalen gleichzeitig zu einer Betriebsspannungsversorgung von elektrischen Bauteilen des Fahrzeugs erfolgen kann. Insbesondere lassen sich auf diese Weise separate Datenleitungen einsparen.

In einer weiteren Ausführungsform befinden sich die Leiter auf einem elektrisch nicht leitfähigen Leitersubstrat. Die Leiter sind demzufolge nicht vollständig isoliert, sondern liegen in mehr oder minder unisolierter Form auf dem Leitersubstrat vor, wobei sie von dem Leitersubstrat gehalten und gegeneinander isoliert werden.

In einer Ausführungsform ist einer der Leiter zur Ausbildung der Überkreuzung S-förmig geführt und der andere Leiter bis zur Überkreuzung gerade geführt. Ab der Überkreuzung ist der andere Leiter wiederum gerade geführt, wobei mindestens ein separates Leiterelement, die beiden gerade geführten Leiterstücke schräg verlaufend miteinander verbindet, und dieses schräg verlaufende, separate Leiterelement im S-Bereich des einen Leiters geführt, mit dem einen Leiter aber nicht elektrisch verbunden ist. Die Überkreuzung wird demzufolge derart durchgeführt, dass der eine Leiter S-förmig geführt ist, während der andere Leiter gerade geführt, aber im S-Bereich des einen Leiters unterbrochen ist. Bevorzugt ist der S-förmig geführte Leiter derart geführt, dass er nach Verlassen seines S-Bereichs mit dem unterbrochenen, gerade geführten anderen Leiter fluchtet. Die beiden unterbrochenen, gerade geführten, anderen Leiter liegen demzufolge einmal links, einmal rechts des S-Bereichs. Diese beiden gerade geführten, anderen Leiterstücke werden mittels des separaten Leiterelements leitend miteinander verbunden, wobei aber das separate Leiterelement mit dem S-förmig geführten einen Leiter nicht elektrisch verbunden ist.

Das separate Leiterelement ist erfindungsgemäß mittels eines elektrisch nicht leitenden Stützapparates an mindestens einem der Leiter gehalten. Der Stützapparat dient folglich dem Halten des separaten Leiterelements. Der Stützapparat ist hierbei mindestens einem der Leiter zugeordnet.

In einer weiteren Ausführungsform ist das separate Leiterelement mit den Leiterstücken elektrisch verbunden, insbesondere verschweißt. Selbstverständlich kommen auch andere Arten der Verbindung in Betracht, insbesondere solche, die sich leicht und kostengünstig herstellen lassen und nur eine kurze Prozesszeit benötigen, wie beispielsweise Nieten, Verpressen, Verlöten.

Erfindungsgemäß weist der Stützapparat mindestens ein Querelement auf, das sich an den beiden Leitern mit Abstand zur Überkreuzung abstützt, wobei von dem Querelement ein Ausleger ausgeht, an dem das separate Leiterelement befestigt ist. Der Stützapparat stützt sich folglich über sein Querelement an den beiden Leitern dergestalt ab, dass das Querelement mit Abstand zur Überkreuzung liegt. Von diesem Querelement geht der Ausleger raus, an dem das separate Leiterelement befestigt ist. Das separate Leiterelement wird folglich von dem Ausleger gehalten. Der Ausleger wiederum wird vom Querelement gehalten, das sich an den Leitern abstützt beziehungsweise auf diesen hält, beispielsweise mittels einer Klemmung. Eine solche Befestigungsweise ist schnell und kostengünstig herstellbar.

In einer weiteren Ausführungsform ist der Stützapparat oder zumindest ein Abschnitt desselben im Kunststoffspritzverfahren, insbesondere im Kunststoffumspritzverfahren, erstellt. Der Stützapparat ist aus Kunststoff sehr leicht und kostengünstig herstellbar. Er kann hierbei eine solche Ausgestaltung aufweisen, in der er als Kunststoffbauteil mindestens einen, vorzugsweise beide Leiter umgreift, beispielsweise klemmend beaufschlagt und sich so an den Leitern abstützt. Er kann auch in einer solchen Weise hergestellt sein, dass er im Kunststoffumspritzverfahren um die Leiter herum aufgespritzt ist. Es lässt sich hierdurch eine definierte, vorgegebene Anordnung der Leiter bereits durch das Umspritzen oder abschnittsweise Umspritzen zur Ausbildung des Stützapparates erzielen.

In einer der Ausführungsformen ist das separate Leiterelement einstückig mit einem der beiden gerade geführten Leiterstücke ausgebildet. Dieses eine Leiterstück wird demzufolge in einer solchen Art und Weise ausgebildet, dass sich die Ausführung der Überkreuzung durch Übereinanderlegen des anderen Leiters und des einen Leiters ergibt, wobei die Leiter beabstandet zueinander liegen. Zur Sicherstellung dieser Beabstandung kann der Stützapparat oder ein Stütz- beziehungsweise Isolierelement insbesondere im Bereich der Überkreuzung eingebracht werden, vorzugsweise in einer solchen Art und Weise, dass sich beide Leiter im Bereich der Überkreuzung daran abstützen.

Weitere vorteilhafte Ausführungsformen ergeben sich aus den Unteransprüchen und aus Kombinationen derselben.

### Kurze Beschreibung der Zeichnungen

Die Erfindung wird nachfolgend anhand von Ausführungsbeispielen näher erläutert, ohne aber hierauf beschränkt zu sein.

Es zeigen
- Figur 1: eine Überkreuzung zweier Leiter, die auf einem flexiblen Substrat ausgebildet sind,
- Figur 2: eine Stanzgitteranordnung mit zwei Leitern, einer Überkreuzung mit einem separaten Leiterelement als Brückenelement und einem dieses haltenden Stützapparat und
- Figur 3: eine Stanzgitteranordnung mit einem durch Verlagerung verbundenen, einstückig zu einem gerade geführten Leiterstück ausgebildeten Brückenelement.

### Ausführungsform(en) der Erfindung

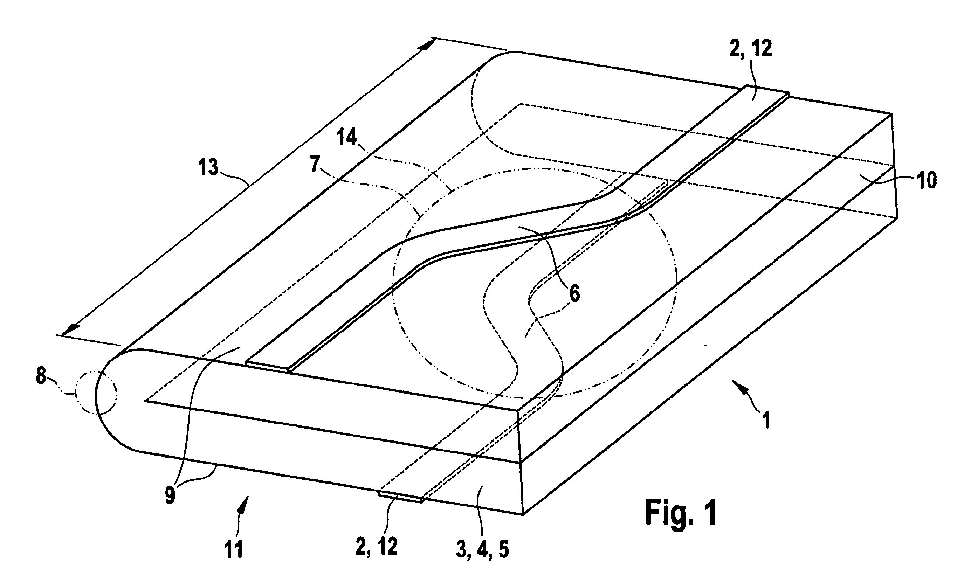

Figur 1 zeigt eine beispielhafte Leitungsanordnung 1 mit zwei im Wesentlichen parallel geführten elektrischen Leitern 2. Die elektrischen Leiter 2 sind auf einem Substrat 3 einseitig aufgebracht, das als elektrisch nicht leitfähiges Leitersubstrat 4 und als flexibles Substrat 5 ausgebildet ist. Jeder der beiden Leiter 2 weist eine S-förmige Ausbildung 6 auf, wobei die beiden Leiter 2 und die S-förmigen Ausbildungen 6 bei planparalleler Anordnung der beiden Leiter 2 auf ebenem, also noch nicht geklapptem oder gefaltetem Substrat 3, gleichsinnig ausgerichtet sind. Die beiden Leiter 2 weisen im planparallelen, also nicht gefalteten Zustand des Substrats 3, demnach im Wesentlichen denselben Abstand zueinander über ihren Verlauf auf. Zur Ausbildung einer Überkreuzung 7 wird das Substrat 3 in einer solchen Art und Weise an einer Faltstelle 8 gefaltet beziehungsweise geknickt, dass die beiden Leiter 2 in Gegenüberlage zueinander kommen, dergestalt, dass ihre S-förmigen Ausbildungen 6 so übereinander liegen, dass die beiden Leiter 2 vor und nach der ausgebildeten Überkreuzung 7 in ihrem Verlauf wechselseitig fluchten. Vorzugsweise erfolgt eine Faltung 11 an der Faltstelle 8 in einer solchen Art und Weise, dass eine Leiterseite 9 des Substrats 3 nach außen gekehrt wird, also eine direkte, plane Aneinanderlage des Substrats 3 nach der Faltung 11 erfolgen kann, ohne dass sich die Leiter 2 elektrisch berühren. Kumulativ oder alternativ hierzu können die Leiter 2 mit einer elektrisch nicht leitenden Schicht überzogen sein, so dass auch eine Faltung 11 an der Faltstelle 8 in entgegengesetzter Richtung vorgenommen werden kann, dergestalt, dass Leiterseiten 9 sich direkt gegenüberliegen, also genau anders als in Figur 1 dargestellt. Besonders bevorzugt ist das Substrat 3 ein doppellagiges Substrat 10, wobei zwischen zwei unmittelbar aufeinander liegenden Lagen des doppellagigen Substrats 10 die Leiter 2 ober- und unterseitig durch die Lagen des Substrats 3 isoliert geführt sind. Bei einer so erfolgenden Faltung 11 können sich die Leiter 2 dann in keinem Fall in unerwünschter Weise elektrisch berühren, insbesondere nicht im Bereich der Überkreuzung 7. Gerade in Fällen, in denen die Leiter 2 als Leiterbahnen 12 ausgebildet sind, ist eine solche Leitungsführung besonders einfach und kostengünstig möglich. Hinsichtlich einer elektrischen Länge 13 der Leiter 2 im zu betrachtenden, im Wesentlichen parallel geführten Abschnitt liegt die Überkreuzung 7 zumindest in etwa mittig der elektrischen Länge 13, um die größtmögliche Entkoppelung der Leiter 2 von der Umgebung zu erreichen. Durch die Faltung 11 erfolgt die zur Ausbildung der Überkreuzung 7 erforderliche Überdeckung 14 der beiden Leiter 2, nämlich der Leiterbahnen 12.

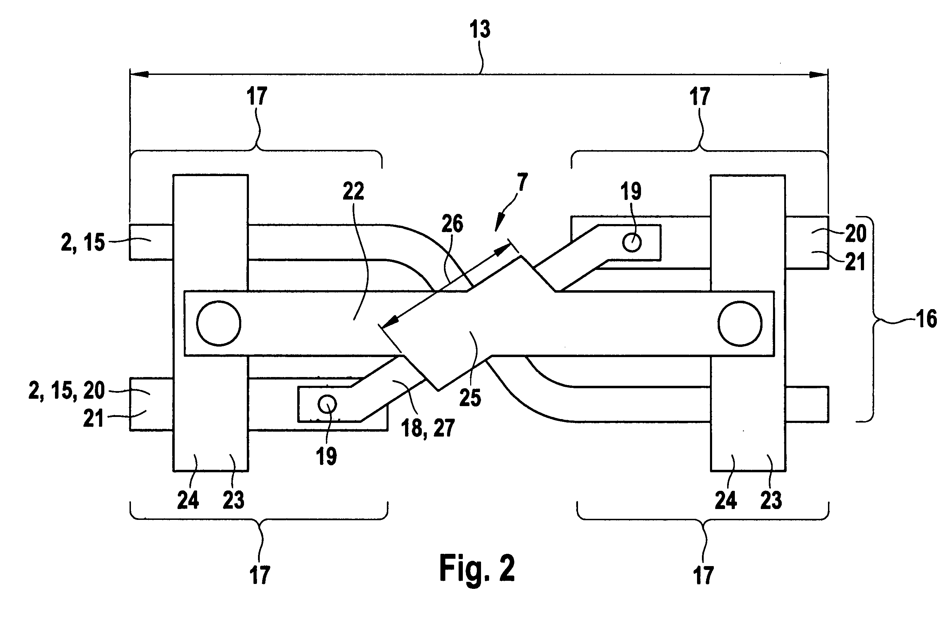

In einer Ausführungsform der Erfindung, wie sie aus Figur 2 ersichtlich ist, sind die beiden Leiter 2 abschnittsweise parallel geführt und als Stanzgitterbahnen 15 eines Stanzgitters 16 ausgebildet. Die Leiter 2 sind hierbei in Abschnitten 17 parallel geführt, wobei die Abschnitte 17 lediglich von der Überkreuzung 7 unterbrochen werden. Die Überkreuzung 7 wird in dieser Ausführungsform so erzielt, dass die Überkreuzung 7 mindestens ein separates, elektrisch verbundenes Leiterelement 18 als Brückenelement 27 aufweist, wobei die elektrische Verbindung an Verbindungsstellen 19 erfolgt. Einer der beiden Leiter 2 ist zur Ausbildung der Überkreuzung 7 S-förmig geführt, und der andere Leiter 2, 20 bis zur Überkreuzung gerade geführt, an der Überkreuzung zunächst unterbrochen und danach wieder gerade geführt, allerdings an der nun anderen Seite des S-förmig geführten Leiters 2. Hierdurch bilden sich an dem gerade geführten Leiter 2 Leiterstücke 21 aus, die im Bereich der Überkreuzung 7 unterbrochen und durch das Leiterelement 18 über die Verbindungsstelle 19 wieder elektrisch verbunden sind. Die Verbindungsstellen 19 können beispielsweise durch Verschweißung hergestellt werden, was eine billige, leicht herzustellende und hoch stromtragfähige elektrische Verbindung ergibt. Das Leiterelement 18 ist im Bereich der Überkreuzung 7 von einem elektrisch nicht leitenden Stützapparat 22 gehalten, wobei sich der Stützapparat 22 an den beiden Leitern 2 an seinen sich jeweils gegenüberliegenden Enden mit Querelementen 23 abstützt. Die Querelemente 23 verlaufen quer zu den Leitern 2 und beaufschlagen diese beispielsweise oberseitig; insbesondere ist es möglich, die Querelemente 23 aus Kunststoff 24 zu fertigen und sie federnd auf die Leiter 2 aufzustecken, so dass sie sich auf den Leitern 2 durch eine über den federnden Kunststoff 24 aufgebrachte Klemmkraft halten. Zwischen den beiden Querelementen 23 ist ein Ausleger 25 angeordnet, insbesondere mit den Querelementen 23 verbunden oder einstückig zu den Querelementen 23 ausgebildet. Der Ausleger 25 trägt das Leiterelement 18. Insbesondere ist vorgesehen, dass das Leiterelement 18 zumindest abschnittsweise, nämlich in seinem Mittelabschnitt 26, von Material des Auslegers 25 umgegeben, insbesondere mit Kunststoff 24 umspritzt ist. Die Überkreuzung 7 ist wiederum zumindest im Wesentlichen in der elektrischen Mitte der elektrischen Länge 13 der Leiter 2 ausgebildet.

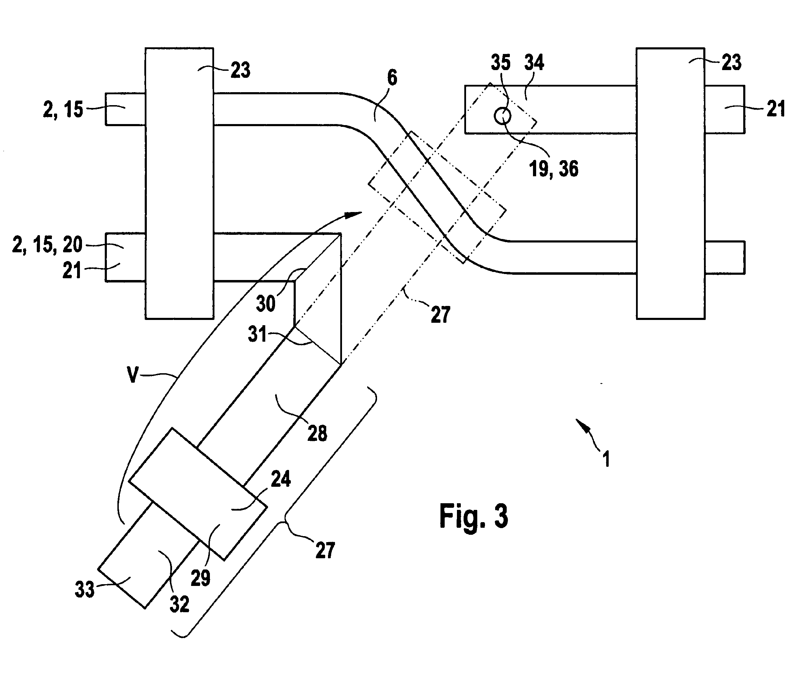

Figur 3 zeigt eine Leitungsanordnung 1 mit zwei Leitern 2, wie bereits zu Figur 2 beschrieben, wobei die Leiter 2 als Stanzgitterbahnen 15 ausgebildet sind und einer der beiden Leiter 2 S-förmig geführt ist, also eine S-förmige Ausbildung 6 aufweist. Die beiden Leiter 2 werden durch Querelemente 23 beabstandet voneinander gehalten. Der andere Leiter 20, der nicht die S-förmige Ausbildung 6 aufweist, ist, wie bereits in Figur 2 beschrieben, im Wesentlichen gerade geführt und unterbrochen, wobei ein erster Leiterteil 28 in etwa V-förmig über die Längserstreckung der Leitungsanordnung 1 hinaus annähernd quer geführt und ebenfalls mit einem aus Kunststoff 24 bestehenden Distanzelement 29 versehen ist. Der erste Leiterteil 28 weist eine rechtwinklige Abzweigung 30 auf, die den ersten Leiterteil 28 quer zur Axialerstreckung des anderen Leiters 20 erstreckt. An diese rechtwinklige Abzweigung 30 und eine erste rechtwinklige Erstreckung anschließend folgt eine winklige Abzweigung 31, die dergestalt ausgebildet ist, dass bei Abknicken/Verformen in der winkligen Abzweigung 31 der über diese hinaus ragende, das Distanzelement 29 tragende Leiterrest 32 als Brückenelement 27 sich über die S-förmige Ausbildung 6 erstreckt und das Distanzelement 29 nach abknickender Verlagerung des Leiterelements 32 in etwa über der S-förmigen Ausbildung 6 liegt, um einen unerwünschten Berührkontakt zwischen den beiden Leitern 2 zu verhindern. In einem Leiterendbereich 33 des Leiterrests 32, der auf einem Verbindungsbereich 34 des gerade geführten anderen Leiters 20 in Gegenüberlage der S-förmigen Ausbildung 6 liegt, erfolgt nach dem Umformen/Verlagern des Leiterrests 32 zur Ausbildung des Brückenelements 27 eine Verbindung 35 unter Herstellung der Verbindungsstelle 19, beispielsweise als Schweißpunkt 36. Die Verlagerung in Richtung des Pfeils V in der winkligen Abzweigung 31, insbesondere durch Kaltverformen wie etwa Stanzen, stellt somit aus dem Leiterrest 32 das Brückenelement 27 zur Verbindung der anderen Leiter 20 zur Verfügung, wobei das Brückenelement 27 einstückig mit dem anderen Leiter 20, nämlich einem der Leiterstücke 21, ausgebildet und mit dem anderen Leiterstück 21 an der Verbindungsstelle 19 verbunden, insbesondere über den Schweißpunkt 36 verschweißt ist.

## Patentansprüche

1. Elektrische, insbesondere einer Datenübertragung dienende Leitungsanordnung mit mindestens zwei im Wesentlichen parallel geführten elektrischen Leitern, wobei die Leiter (2) mindestens eine Überkreuzung (7) besitzen, die mindestens ein separates, elektrisch verbundenes Leiterelement (18) aufweist, wobei die Leiter (2) auf einem flexiblen Substrat (5) ausgebildet sind, **dadurch gekennzeichnet, dass** das separate Leiterelement (18) mittels eines elektrisch nicht leitenden Stützapparats (22) an beiden Leitern (2, 20) gehalten ist, wobei der Stützapparat (22) mindestens ein Querelement (23) aufweist, das sich an den beiden Leitern (2,20) mit Abstand zur Überkreuzung (7) mittels einer Klemmung abstützt und wobei von dem Querelement (23) ein Ausleger (25) ausgeht, an dem das separate Leiterelement (18) befestigt ist.

2. Leitungsanordnung nach Anspruch 1, **dadurch gekennzeichnet, dass** die Überkreuzung in oder im Wesentlichen in einer elektrischen Mitte einer elektrischen Länge (13) der Leiter (2) ausgebildet ist.

3. Leitungsanordnung nach einem der vorhergehenden Ansprüche, **dadurch gekennzeichnet, dass** die Leiter (2) als Leiterbahnen (12) ausgebildet sind.

4. Leitungsanordnung nach einem der vorhergehenden Ansprüche, **dadurch gekennzeichnet, dass** die Leiter (2) als Stanzgitterbahnen (15) ausgebildet sind.

5. Leitungsanordnung nach einem der vorhergehenden Ansprüche, **dadurch gekennzeichnet, dass** sich die Leiter (2) auf einem elektrisch nicht leitfähigen Leitersubstrat (4) befinden.

6. Leitungsanordnung nach einem der vorhergehenden Ansprüche, **dadurch gekennzeichnet, dass** einer der Leiter (2) zur Ausbildung der Überkreuzung (7) S-förmig geführt ist und dass der andere Leiter (2,20) bis zur Überkreuzung (7) gerade geführt und ab der Überkreuzung (7) wiederum gerade geführt ist und dass das separate Leiterelement (18) die beiden gerade geführten Leiterstücke (21) schräg verlaufend im S-Bereich des einen Leiters (2) verbindet und mit dem einen Leiter (2) elektrisch nicht verbunden ist.

7. Leitungsanordnung nach einem der vorhergehenden Ansprüche, **dadurch gekennzeichnet, dass** das separate Leiterelement (18) mit den Leiterstücken (21) elektrisch verbunden, insbesondere verschweißt, ist.

8. Leitungsanordnung nach einem der vorhergehenden Ansprüche, **dadurch gekennzeichnet, dass** der Stützapparat (22) oder zumindest ein Abschnitt (17) davon im Kunststoffspritzverfahren, insbesondere im Kunststoffumspritzverfahren, erstellt ist.

9. Leitungsanordnung nach einem der vorhergehenden Ansprüche, **dadurch gekennzeichnet, dass** das separate Leiterelement (18) einstückig mit einem der beiden gerade geführten Leiterstücke (21) ausgebildet und zur Ausbildung der Überkreuzung (7) verformt und zumindest abschnittsweise verlagert ist.

10. Leitungsanordnung nach einem der vorhergehenden Ansprüche, **dadurch gekennzeichnet, dass** die Verlagerung des separaten Leiterelements (18) durch einen Umformungsvorgang, insbesondere eine Kaltverformung, bewirkt ist.

## Claims

1. Electrical conduction arrangement which serves, in particular, for data transmission and has at least two electrical conductors which are routed substantially parallel, wherein the conductors (2) have at least one crossover point (7) which has at least one separate, electrically connected conductor element (18), wherein the conductors (2) are formed on a flexible substrate (5), **characterized in that** the separate conductor element (18) is held on the two conductors (2, 20) by means of an electrically non-conductive supporting apparatus (22), wherein the supporting apparatus (22) has at least one transverse element (23) which is supported on the two conductors (2, 20) at a distance from the crossover point (7) by means of a clamping means, and wherein an extension arm (25) extends from the transverse element (23), the separate conductor element (18) being attached to the said extension arm.

2. Conduction arrangement according to Claim 1, **characterized in that** the crossover point is formed in or substantially in an electrical centre of an electrical length (13) of the conductors (2).

3. Conduction arrangement according to either of the preceding claims, **characterized in that** the conductors (2) are in the form of conductor tracks (12).

4. Conduction arrangement according to one of the preceding claims, **characterized in that** the conductors (2) are in the form of leadframe tracks (15).

5. Conduction arrangement according to one of the preceding claims, **characterized in that** the conductors (2) are located on an electrically non-conductive conductor substrate (4).

6. Conduction arrangement according to one of the preceding claims, **characterized in that** one of the conductors (2) is routed in an S-shaped manner in order to form the crossover point (7), and **in that** the other conductor (2, 20) is routed in a straight line as far as the crossover point (7) and is routed in a straight line again starting from the crossover point (7), and **in that** the separate conductor element (18) connects the two conductor pieces (21), which are routed in a straight line, in a manner running obliquely in the S-region of the one conductor (2) and is not electrically connected to the one conductor (2).

7. Conduction arrangement according to one of the preceding claims, **characterized in that** the separate conductor element (18) is electrically connected, in particular welded, to the conductor pieces (21).

8. Conduction arrangement according to one of the preceding claims, **characterized in that** the supporting apparatus (22) or at least one section (17) of the said supporting apparatus is created using the plastic injection-moulding process, in particular using the plastic extrusion coating process.

9. Conduction arrangement according to one of the preceding claims, **characterized in that** the separate conductor element (18) is integrally formed with one of the two conductor pieces (21) which are routed in a straight line and is deformed in order to forms the crossover point (7) and is displaced at least in sections.

10. Conduction arrangement according to one of the preceding claims, **characterized in that** the displacement of the separate conductor element (18) is effected by a reshaping process, in particular cold deformation.

## Revendications

1. Dispositif de câble électrique, servant notamment à une transmission de données, avec au moins deux conducteurs électriques guidés pour l'essentiel parallèlement, les conducteurs (2) possédant au moins une intersection (7) comportant au moins un élément conducteur (18) séparé, relié sur le plan électrique, les conducteurs (2) étant réalisés sur un substrat (5) flexible, **caractérisé en ce que** l'élément conducteur (18) séparé est maintenu au niveau des conducteurs (2, 20) à l'aide d'un appareil de maintien (22) électriquement non conducteur, l'appareil de maintien (22) comportant au moins un élément transversal (23) s'appuyant contre les deux conducteurs (2, 20) à une certaine distance de l'intersection (7) à l'aide d'un organe de serrage ainsi qu'un portant (25) auquel l'élément conducteur (18) séparé est fixé partant de l'élément transversal (23).

2. Dispositif de câble selon la revendication 1, **caractérisé en ce que** l'intersection est réalisée dans ou pour l'essentiel dans le centre électrique d'une longueur électrique (13) des conducteurs (2).

3. Dispositif de câble selon l'une quelconque des revendications précédentes, **caractérisé en ce que** les conducteurs (2) prennent la forme de pistes conductrices (12).

4. Dispositif de câble selon l'une quelconque des revendications précédentes, **caractérisé en ce que** les conducteurs (2) prennent la forme de pistes de grille estampée (15).

5. Dispositif de câble selon l'une quelconque des revendications précédentes, **caractérisé en ce que** les conducteurs (2) se trouvent sur un substrat de conducteur (4) électriquement non conducteur.

6. Dispositif de câble selon l'une quelconque des revendications précédentes, **caractérisé en ce qu'**un des conducteur (2) est guidé en forme de S pour former l'intersection (7) et que l'autre conducteur (2, 20) est guidé tout droit jusqu'à l'intersection (7) et guidé de nouveau tout droit à partir de l'intersection (7) et que l'élément conducteur (18) séparé relie les deux pièces de conducteur (21) guidées tout droit et s'étendant en oblique dans la région en S du premier conducteur (2) et n'est pas relié sur le plan électrique avec ledit conducteur (2).

7. Dispositif de câble selon l'une quelconque des revendications précédentes, **caractérisé en ce que** l'élément conducteur (18) séparé est relié sur le plan électrique aux pièces de conducteur (21), notamment soudé.

8. Dispositif de câble selon l'une quelconque des revendications précédentes, **caractérisé en ce que** l'appareil de maintien (22) ou au moins une section (17) de celui-ci est fabriqué selon un procédé d'injection de matière plastique, notamment selon un procédé de moulage par injection de matière plastique.

9. Dispositif de câble selon l'une quelconque des revendications précédentes, **caractérisé en ce que** l'élément conducteur (18) séparé est fabriqué d'un seul tenant avec une des deux pièces de conducteurs (21) guidées tout droit et déformé pour former l'intersection (7) et déplacé au moins par endroits.

10. Dispositif de câble selon l'une quelconque des revendications précédentes, **caractérisé en ce que** le déplacement de l'élément conducteur (18) séparé est réalisé par le biais d'un processus de déformation, notamment une déformation à froid.
